# EUROPÄISCHE PATENTANMELDUNG

(11) **EP 3 800 773 A1**
(43) Veröffentlichungstag der Anmeldung: **07.04.2021**
(21) Anmeldenummer: 19200822.5
(22) Anmeldetag: 01.10.2019
(51) Int. Cl.: H02M 3/28, H02M 3/335, G01R 19/00

(54) **SPERRWANDLER MIT BESTIMMUNG DER PRIMÄRSPANNUNG IM SEKUNDÄRKREIS**

(71) Anmelder: Siemens Aktiengesellschaft, 80333 München (DE)
(72) Erfinder: Kapp, Harald, 10709 Berlin (DE)

(57) **Zusammenfassung**

Die Erfindung betrifft einen Sperrwandler (10) und ein Verfahren zum Betreiben eines solchen Sperrwandlers (10).

Der erfindungsgemäße Sperrwandler (10) weist einen Primärkreis (11) und einen Sekundärkreis (12) auf, wobei der Primärkreis (11) wenigstens einen Schalter (22), einen Kontroller (23) zum Ansteuern des Schalters (22) und eine Primärinduktivität (21) umfasst und wobei der Sekundärkreis (12) wenigstens eine magnetisch mit der Primärinduktivität (21) gekoppelte Sekundärinduktivität (41), ein Speisegleichrichterelement (42) und einen Pufferkondensator (40) umfasst. Das Speisegleichrichterelement (42) ist dabei dazu ausgebildet, einen Strom von der Sekundärinduktivität (41) in einer Speisestromrichtung in den Pufferkondensator (40) fließen zu lassen und entgegen der Speisestromrichtung zu sperren. Erfindungsgemäß sind ferner ein in dem Sekundärkreis (12) angeordneter zweiter Kondensator (50) und ein zwischen den zweiten Kondensator (50) und die Sekundärinduktivität (41) geschaltetes zweites Gleichrichterelement (52) vorgesehen. Das zweite Gleichrichterelement (52) ist dabei dazu ausgebildet, einen Messstrom in den zweiten Kondensator (50) fließen zu lassen, wenn das Speisegleichrichterelement (42) den Strom von der Sekundärinduktivität (41) entgegen der Speisestromrichtung sperrt.

## Beschreibung

### Technisches Gebiet

Die Erfindung betrifft einen Sperrwandler und ein Verfahren zum Betreiben eines solchen Sperrwandlers.

### Technischer Hintergrund

Sperrwandler oder auch englisch Flyback-Converter finden im Stand der Technik weite Verwendung als DC/DC-Umsetzer oder auch bei vorgeschaltetem Gleichrichter als AC/DC-Umsetzer. Sperrwandler werden insbesondere als Tiefsetzsteller eingesetzt, um eine Eingangsspannung in eine im Verhältnis zu der Eingangsspannung niedrigere Ausgangsspannung umzusetzen. Dabei besitzen Sperrwandler den Vorteil, die Ausgangsspannung galvanisch von der Eingangsspannung abzutrennen. Diese vorteilhafte Eigenschaft erreichen Sperrwandler durch eine magnetische Kopplung eines mit der Eingangsspannung verbundenen Primärkreises mit einem ausgangsseitigen Sekundärkreis.

Sperrwandler finden beispielsweise in Schaltnetzteilen und bei batteriegespeisten Anwendungen Verwendung, wo ihre Eigenschaft der galvanischen Trennung der unter Umständen hohen Eingangsspannung des Sperrwandlers von der Ausgangsspannung des Sperrwandlers aus Gründen der Betriebssicherheit von besonderem Interesse ist.

Allgemein wird bei Sperrwandlern während einer Pufferphase ein Strom aus der Eingangsspannungsquelle durch die Primärinduktivität erzeugt, so dass die Primärinduktivität ein Magnetfeld aufbaut. Anschließend wird der Strom durch die Primärinduktivität während einer Speisephase unterbrochen, so dass sich die in dem Magnetfeld gespeicherte Energie über die magnetisch mit der Primärinduktivität gekoppelte Sekundärinduktivität in einen von der Sekundärinduktivität gespeisten Pufferkondensator entlädt. Über das Windungsverhältnis der Primärinduktivität und der Sekundärinduktivität kann dabei ein Hochsetzen oder Tiefsetzen der Eingangsspannung des Sperrwandlers erfolgen.

Während der Pufferphase des Sperrwandlers fließt durch die Sekundärinduktivität gemäß Stand der Technik kein Strom, so dass die Versorgung der an den Sekundärkreis angeschlossenen Last aus dem Pufferkondensator erfolgt. Da das Funktionsprinzip von Sperrwandlern im Stand der Technik wohlbekannt ist, soll an dieser Stelle auf eine weitergehende Darstellung verzichtet werden.

In vielen Anwendungen von Sperrwandlern, wie beispielsweise batterieversorgten Anwendungen, ist die Kenntnis des Zustandes der Eingangsspannung des Sperrwandlers für den Betrieb des von dem Sperrwandler versorgten Lastschaltkreises von Interesse. Da die galvanische Trennung des Sekundärkreises von dem Primärkreis des Sperrwandlers nicht durch Messverbindungen aufgehoben werden soll, ist hierzu bekannt, die an dem Primärkreis anliegende Eingangsspannung im Primärkreis zu bestimmen und ein Ergebnis der Bestimmung datentechnisch als Digitalsignal oder über beispielsweise einen Optokoppler als Analogsignal von dem Primärkreis an den Sekundärkreis zu übermitteln. Dabei muss also zusätzlicher Schaltungsaufwand für die galvanische Trennung der Informationsübermittlung von dem Primärkreis in den Sekundärkreis betrieben werden.

Die Erfindung macht es sich daher zur Aufgabe, einen verbesserten Sperrwandler einzuführen, der es erlaubt, dem Sekundär- beziehungsweise Lastkreis eine Information über den Zustand der Eingangsspannung des Sperrwandlers unter Erhaltung der galvanischen Trennung von Primärkreis und Sekundärkreis des Sperrwandlers zur Verfügung zu stellen. Ferner macht es sich die Erfindung zur Aufgabe, ein entsprechend verbessertes Verfahren für das Betreiben eines Sperrwandlers einzuführen.

### Zusammenfassung der Erfindung

Ein erster Aspekt der Erfindung löst diese Aufgabe durch einen neuartigen Sperrwandler mit einem Primärkreis und einem Sekundärkreis, bei dem der Primärkreis wenigstens einen Schalter, einen Kontroller zum Ansteuern des Schalters und eine Primärinduktivität umfasst und bei dem der Sekundärkreis wenigstens eine magnetisch mit der Primärinduktivität gekoppelte Sekundärinduktivität, ein Speisegleichrichterelement und einen Pufferkondensator umfasst. Das Speisegleichrichterelement ist dabei dazu ausgebildet, einen Strom von der Sekundärinduktivität in einer Speisestromrichtung in den Pufferkondensator fließen zu lassen und entgegen der Speisestromrichtung zu sperren. Erfindungsgemäß sind ferner ein in dem Sekundärkreis angeordneter zweiter Kondensator und ein zwischen den zweiten Kondensator und die Sekundärinduktivität geschaltetes zweites Gleichrichterelement vorgesehen. Das zweite Gleichrichterelement ist dabei dazu ausgebildet, einen Messstrom in den zweiten Kondensator fließen zu lassen, wenn das Speisegleichrichterelement den Strom von der Sekundärinduktivität entgegen der Speisestromrichtung sperrt.

Die Erfindung beruht auf der Erkenntnis und schließt diese mit ein, dass die magnetisch gekoppelten Primär- und Sekundärinduktivitäten während der Pufferphase des Sperrwandlers ähnlich einem Transformator wirken, so dass sich während der Pufferphase an den Klemmen der Sekundärinduktivität eine durch die Klemmspannung der Primärinduktivität und das Windungsverhältnis von Primär- und Sekundärinduktivität bestimmte Spannung einstellt. Da das Windungsverhältnis bekannt ist, kann von der Spannung über die Sekundärinduktivität auf den Zustand der Eingangsspannung des Sperrwandlers rückgeschlossen werden, wenn die genannte Spannung der Sekundärinduktivität im Sekundärkreis des Sperrwandlers bestimmt wird. Der erfindungsgemäße Sperrwandler nutzt diese Erkenntnis, indem er während der Pufferphase, während der der Pufferkondensator und der ausgangsseitig an den Sperrwandler angeschlossene Lastkreis von der Sekundärinduktivität abgetrennt ist, einen Strom in den zweiten Kondensator fließen lässt, woraufhin sich über den zweiten Kondensator die Klemmspannung oder einer von der Klemmspannung der Sekundärinduktivität in bekannter Weise abgeleitete Kondensatorspannung einstellt. Diese Kondensatorspannung kann nun im Sekundärkreis mit den üblichen im Stand der Technik bekannten Mitteln bestimmt werden, woraufhin aus der bestimmten Kondensatorspannung auf die Eingangsspannung des Sperrwandlers rückgeschlossen werden kann. Die Erfindung bietet somit den Vorteil, bei minimalem Schaltungsaufwand und unter Beibehaltung der galvanischen Trennung von Primärkreis und Sekundärkreis des Sperrwandlers im Sekundärkreis eine Information über den Zustand der Eingangsspannung des Sperrwandlers zur Verfügung zu stellen.

Bei Ausführungsformen der Erfindung kann wenigstens eines von Speisegleichrichterelement und zweitem Gleichrichterelement als Diode ausgebildet sein. Diese Ausführungsformen sind schaltungstechnisch besonders einfach auszuführen.

Alternativ oder zusätzlich kann wenigstens eines von Speisegleichrichterelement und zweitem Gleichrichterelement als Schalter, insbesondere als Halbleitertransistor, ausgebildet sein und eine über eine galvanische Trennung mit einem jeweils zugeordneten Steuerausgang des Kontrollers verbundene Steuerelektrode aufweisen. Die Verwendung eines solchen Schalters ist insbesondere für das Speisegleichrichterelement von Vorteil, weil die Verlustleistung in einem beispielsweise als Halbleitertransistor ausgebildeten Schalter aufgrund der gegenüber einer Diodenspannung niedrigeren Drain-Source-Spannung des durchgeschalteten Transistors geringer ist. Andererseits ist hierbei im Kontroller der Primärseite zusätzlicher Aufwand für die Steuerung eines solchen Schalters zu betreiben und eine galvanische Trennung beispielsweise anhand eines Optokopplers vorzusehen, weswegen die Wahl zwischen Diode und Halbleitertransistor nach den Umständen des Einzelfalls zu treffen ist.

Der zweite Kondensator ist vorzugsweise zwischen einen Kontakt des zweiten Gleichrichterelements und ein festes Bezugspotential des Sekundärkreises, beispielsweise die negative Versorgungsspannung des Sekundärkreises, geschaltet. Dadurch kann die Klemmspannung der Sekundärinduktivität unmittelbar aus der Kondensatorspannung abgeleitet werden.

Bevorzugt besitzt der Sperrwandler der Erfindung einen mit dem zweiten Kondensator verbundenen Entladekreis, der ausgebildet ist, den zweiten Kondensator zu entladen. Indem der zweite Kondensator wiederholt oder fortlaufend entladen wird, wird es möglich, zeitliche Veränderungen der Eingangsspannung des Sperrwandlers auf die Kondensatorspannung des zweiten Kondensators abzubilden.

Beispielsweise kann der Entladekreis einen Entladewiderstand umfassen, der insbesondere parallel zu dem zweiten Kondensator geschaltet sein kann. Der Widerstandswert des Entladewiderstands sollte dabei so bemessen werden, dass der zweite Kondensator während der Pufferphase zuverlässig auf die Klemmspannung der Sekundärinduktivität aufgeladen werden kann, jedoch auch so niederohmig sein, dass die Kondensatorspannung des zweiten Kondensators während der Speisephase ausreichend, beispielsweise um wenigstens ein Zehntel der nominellen Kondensatorspannung, entladen werden kann.

Der Entladekreis kann auch einen Entladeschalter umfassen, dessen Steuerelektrode über eine galvanische Trennung mit einem zugeordneten Steuerausgang des Kontrollers verbunden ist. Der Entladeschalter kann beispielsweise parallel zu dem zweiten Kondensator geschaltet sein und diesen auf eine entsprechende Ansteuerung durch den Kontroller hin kurzschließen. Um den dabei fließenden Strom zu beschränken, kann der Entladeschalter einen Entladewiderstand enthalten oder einer solcher kann ihm in Reihe geschaltet sein.

Besonders bevorzugt beträgt eine Kapazität des Pufferkondensators wenigstens das Zehnfache einer Kapazität des zweiten Kondensators. Dies besitzt den Vorteil, dass der erfindungsgemäß auch während der Pufferphase durch die Sekundärinduktivität gespeiste Strom im Sekundärkreis verhältnismäßig gering ist, so dass während der Pufferphase von dem im Primärkreis durch die Primärinduktivität fließenden Strom ein stärkeres Magnetfeld aufgebaut werden kann.

Bei allen Ausführungsformen des erfindungsgemäßen Sperrwandlers kann eine Spannungsmesseinheit vorgesehen sein, die mit dem zweiten Kondensator verbunden und dazu ausgebildet ist, eine Spannung über den zweiten Kondensator zu bestimmen. Als Spannungsmesseinheit kann beispielsweise ein Analog-DigitalUmsetzer, einer oder mehrere Komparatoren oder andere vergleichbare Mittel eingesetzt werden. Ebenso ist es möglich, anstelle der Spannung über den zweiten Kondensator mit dieser verbundene physikalische Größen wie beispielsweise den Ladestrom des zweiten Kondensators oder dessen zeitlichen Verlauf zu beobachten, um die Spannung über den zweiten Kondensator zu bestimmen.

Ein Beispiel für eine Einsatzmöglichkeit eines erfindungsgemäßen Sperrwandlers stellt ein Schutz- oder Steuergerät für ein Mittel- oder Hochspannungsnetz dar. Solche Schutz- oder Steuergeräte werden von der Anmelderin unter dem Namen SIPROTEC angeboten. Ein derartiges Schutz- oder Steuergerät ist üblicherweise mit einer Steuereinheit und einem Anschluss für eine sogenannte Hilfsspannung ausgestattet. Die Hilfsspannung kann durch einen externen Anschluss an das Schutz- oder Steuergerät herangeführt oder durch eine an oder in dem Schutz- oder Steuergerät angeordnete Batterie bereitgestellt werden. Im erstgenannten Fall können beispielsweise Wechselspannungen zwischen 115 V und 230 V oder Gleichspannungen zwischen 24 V und 300 V verwendet werden. Bei einer Versorgung aus einer Batterie werden üblicherweise niedrigere Gleichspannungen, beispielsweise 12 V bis 48 V verwendet. Der Einsatzzweck von Schutz- oder Steuergeräten führt zu hohen Ansprüchen an die Verfügbarkeit und Zuverlässigkeit der durch das jeweilige Schutz- oder Steuergerät gebotenen Funktionalität bei der Steuerung und Überwachung eines Mittel- oder Hochspannungsnetzes. Deshalb besteht vielfach seitens der Netzbetreiber der Wunsch, über den Zustand der Hilfsspannung informiert zu werden, um ein Ausfallrisiko eines Schutz- oder Steuergerätes frühzeitig erkennen zu können. Demzufolge ist es von Vorteil, einen erfindungsgemäßen Sperrwandler vorzusehen, welcher zwischen den Anschluss für die Hilfsspannung und die Steuereinheit geschaltet und dazu ausgebildet ist, die Steuereinheit des Schutz- oder Steuergerätes aus der Hilfsspannung zu versorgen.

Ein zweiter Erfindungsaspekt führt ein neuartiges Verfahren für das Betreiben eines Sperrwandlers ein. Das Verfahren besitzt die folgenden wiederholt ausgeführten Schritte:
- während einer Pufferphase, Erzeugen eines Stromes durch eine Primärinduktivität eines Primärkreises des Sperrwandlers;
- während der Pufferphase, Versorgen einer an einen Sekundärkreis des Sperrwandlers angeschlossenen Last aus einem Pufferkondensator des Sekundärkreises;
- während einer auf die Pufferphase folgenden Speisephase, Sperren eines Stromes durch die Primärinduktivität; und
- während der Speisephase, Aufladen des Pufferkondensators aus einer mit der Primärinduktivität magnetisch gekoppelten Sekundärinduktivität.

Erfindungsgemäß ist dabei ein während wenigstens eines Teils der Pufferphase ausgeführter Schritt des Erzeugens eines Stromes aus der Sekundärinduktivität in einen zweiten Kondensator vorgesehen. Die von dem Strom aus der Sekundärinduktivität in den zweiten Kondensator bewirkte Spannung über den zweiten Kondensator lässt im Sekundärkreis des Sperrwandlers vorteilhaft einen Rückschluss auf den Zustand der Eingangsspannung des Sperrwandlers zu.

Vorzugsweise umfasst das erfindungsgemäße Verfahren für das Betreiben eines Sperrwandlers zusätzlich einen auf den Schritt des Erzeugens des Stromes aus der Sekundärinduktivität in den zweiten Kondensator folgenden oder fortlaufend ausgeführten Schritt des wenigstens teilweisen Entladens des zweiten Kondensators. Hierdurch werden die oben für den Entladekreis geschilderten Vorteile erreicht.

Besonders bevorzugt umfasst das erfindungsgemäße Verfahren außerdem einen Schritt des Bestimmens einer Spannung über den zweiten Kondensator.

### Kurzbeschreibung der Figuren

Die Erfindung wird nachfolgend anhand von Abbildungen von Ausführungsbeispielen näher erläutert. Es zeigen:
Figur 1 ein erstes Ausführungsbeispiel eines erfindungsgemäßen Sperrwandlers;
Figur 2 ein zweites Ausführungsbeispiel eines erfindungsgemäßen Sperrwandlers;
Figur 3 ein drittes Ausführungsbeispiel eines erfindungsgemäßen Sperrwandlers;
Figur 4 ein Schutz- oder Steuergerät für ein Hoch- oder Mittelspannungsnetz als Anwendungsbeispiel eines erfindungsgemäßen Sperrwandlers; und
Figur 5 ein Flussdiagramm eines Ausführungsbeispiels eines erfindungsgemäßen Verfahrens für das Betreiben eines Sperrwandlers.

### Ausführliche Beschreibung der Figuren

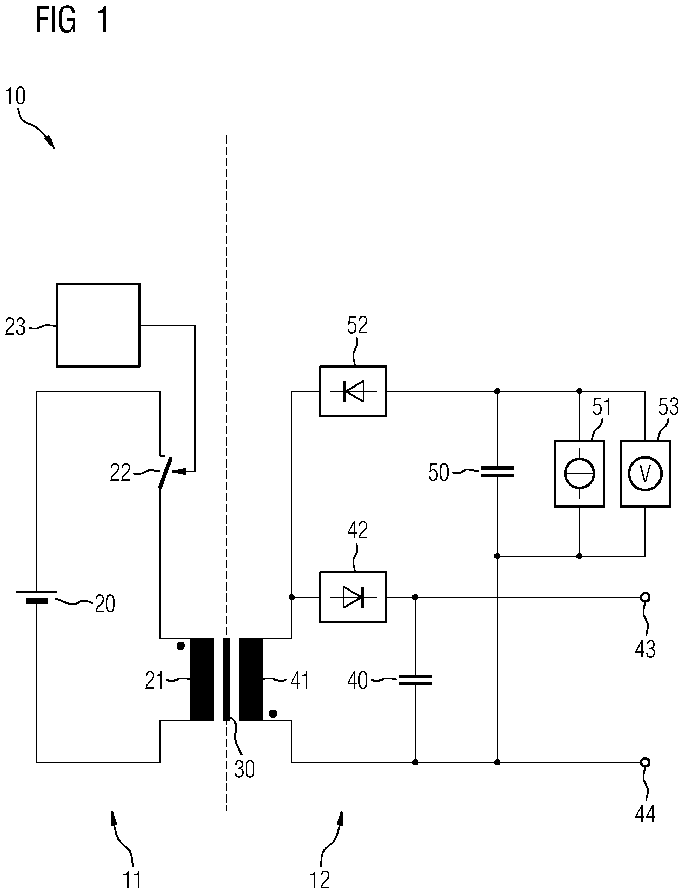

Figur 1 zeigt ein erstes Ausführungsbeispiel eines erfindungsgemäßen Sperrwandlers 10. Ein Primärkreis 11 des Sperrwandlers 10 wird durch eine Gleichspannungsquelle 20 gespeist. Der Zustand der Gleichspannungsquelle 20, bei der es sich beispielsweise um eine Batterie mit abhängig von dem Ladezustand der Batterie variierender Klemmspannung oder ein Energieversorgungsnetz mit Schwankungen unterworfener Netzspannung handeln kann, ist für viele praktische Anwendungen eines Sperrwandlers von Interesse. Allgemein kann im Rahmen der Erfindung anstelle einer Gleichspannungsquelle auch eine Wechselspannungsquelle mit einem nachgeschalteten Gleichrichter verwendet werden. Die Erfindung ermöglicht es, bei geringem zusätzlichen Schaltungsaufwand auf die Spannung und somit den Zustand der Gleichspannungsquelle 20 rückzuschließen.

Der Primärkreis 11 des Sperrwandlers 10 von Figur 1 verfügt wenigstens über eine Primärinduktivität 21 und einen mit der Primärinduktivität 21 verbundenen Schalter 22 sowie einen mit einem Steuereingang des Schalters 22 verbundenen Kontroller 23. Der Kontroller 23 kann durch geeignetes Schließen und Öffnen des Schalters 22, der beispielsweise als Halbleitertransistor ausgebildet sein kann, einen Strom aus der Gleichspannungsquelle 20 durch die Primärinduktivität 21 bewirken oder unterbrechen. Aufgrund des durch sie fließenden Stromes baut die Primärinduktivität 21 ein Magnetfeld auf, das sich bei Unterbrechung des Stromflusses durch die Primärinduktivität aufgrund eines Öffnens von Schalter 22 nicht in den Primärkreis 11 zurück entladen kann.

Die Primärinduktivität 21 ist über einen Magnetkern 30 mit einer Sekundärinduktivität 41 magnetisch gekoppelt. Das von der Primärinduktivität 21 aufgebaute Magnetfeld entlädt sich daher bei Öffnen des Schalters 22 über die Sekundärinduktivität 41 in den Sekundärkreis 12, von dem die Sekundärinduktivität 41 einen Teil bildet. Die galvanische Trennung von Primärkreis 11 und Sekundärkreis 12 wird dadurch erreicht, dass der Primärkreis 11 und der Sekundärkreis 12 lediglich über den Magnetkern 30 miteinander gekoppelt sind, was in den Figuren durch eine durch den Magnetkern 30 verlaufende gestrichelte Linie illustriert wird.

Die Sekundärinduktivität 41 entlädt das von der Primarinduktivität 21 aufgebaute Magnetfeld und erzeugt dabei einen Strom, der durch ein Speisegleichrichterelement 42 auf einen Pufferkondensator 40 fließt und diesen dadurch auflädt. Das Speisegleichrichterelement 42 besitzt dabei die Aufgabe, einen Strom von dem Pufferkondensator 40 in entgegengesetzter Richtung durch die Sekundärinduktivität 41 während der Pufferphase zu unterbinden.

Die Höhe der Spannung über den Pufferkondensator 40 wird wesentlich durch das vom Kontroller 23 vorgegebene Tastverhältnis und die Größe der ausgangsseitig an den Sperrwandler über Lastanschlüsse 43 und 44 angeschlossenen Last bestimmt, weshalb im Rahmen der Erfindung die allgemein im Stand der Technik bekannten Regelungsmechanismen zur Stabilisierung der Ausgangsspannung des Sperrwandlers verwendet werden können.

Bei dem Ausführungsbeispiel der Figur 1 ist ein zweites Gleichrichterelement 52 vorgesehen, das mit der Sekundärinduktivität 41 verbunden ist. Das zweite Gleichrichterelement 52 ist an seinem anderen Ende mit einem zweiten Kondensator 50 verbunden und dazu ausgebildet, den zweiten Kondensator 50 während wenigstens eines Teiles der Pufferphase, während der das Speisegleichrichterelement 42 einen Stromfluss zwischen Primärinduktivität 41 und Pufferkondensator 40 unterbindet, zuzulassen und während der Speisephase zu unterbinden.

Wie bereits erläutert, ergibt sich die Spannung über den zweiten Kondensator 50 aufgrund der Funktionsweise der magnetisch gekoppelten ersten und zweiten Induktivitäten 21, 41 als Transformator unmittelbar aus der Größe der Spannung der Gleichspannungsquelle 20. Die Spannung über den zweiten Kondensator 50 kann beispielsweise durch eine Spannungsmesseinheit 53 bestimmt werden, die in dem gezeigten Ausführungsbeispiel parallel zu dem zweiten Kondensator 50 geschaltet ist. Es sind jedoch auch Ausführungsformen denkbar, bei denen die Spannungsmesseinheit 53 die Spannung über den zweiten Kondensator 50 aus anderen, mit der Spannung verbundenen Messgrößen ableitet, weshalb die Spannungsmesseinheit 53 auch anders verschaltet sein kann.

Das Ausführungsbeispiel der Figur 1 weist außerdem einen Entladekreis 51 auf, der im gezeigten Beispiel ebenfalls parallel zu dem zweiten Kondensator 50 geschaltet ist und die Aufgabe besitzt, den während der Pufferphase aufgeladenen zweiten Kondensator 50 während der Speisephase wenigstens teilweise zu entladen, so dass im Zuge der sich stetig wiederholenden Puffer- und Speisephasen eine zeitliche Veränderung der Spannung der Gleichspannungsquelle 20 im Sekundärkreis 12 verfolgt werden kann.

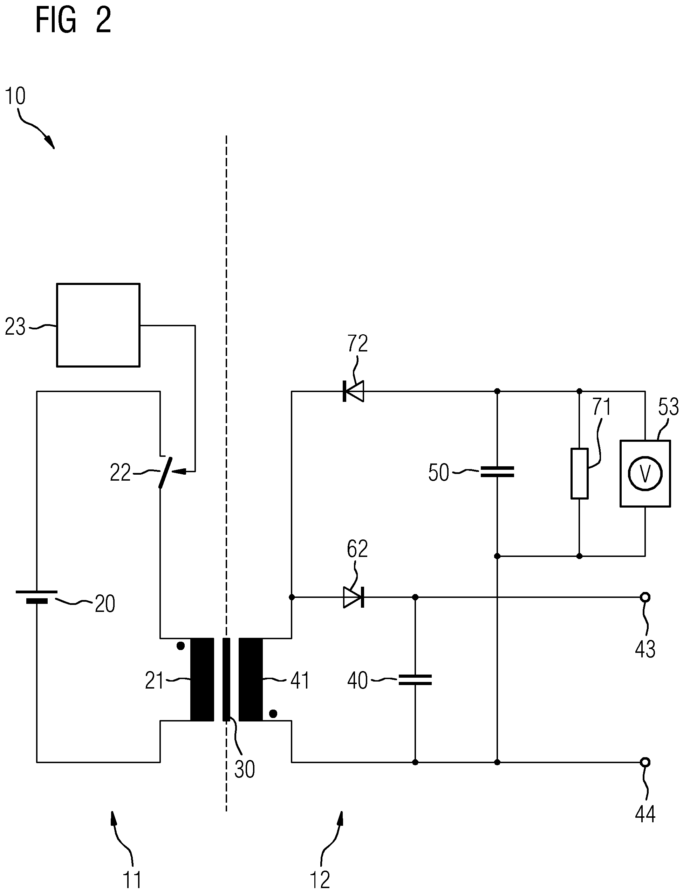

Figur 2 zeigt ein zweites Ausführungsbeispiel eines erfindungsgemäßen Sperrwandlers 10, das in seinem prinzipiellen Aufbau weitgehend dem ersten Ausführungsbeispiel von Figur 1 entspricht. Nachfolgend wird daher ausschließlich auf die Unterschiede der beiden Ausführungsbespiele eingegangen.

Das zweite Ausführungsbespiel des erfindungsgemäßen Sperrwandlers 10 zeichnet sich durch einen besonders einfachen schaltungstechnischen Aufbau aus, der kostengünstig zu realisieren ist. Dabei sind das Speisegleichrichterelement 42 und das zweite Gleichrichterelement 52 des ersten Ausführungsbeispiels als antiparallel zueinander geschaltete Dioden 62 und 72 ausgeführt. Die antiparallele Verschaltung der Dioden 62 und 72 bewirkt den erfindungsgemäß vorgesehenen Stromfluss durch die Sekundärinduktivität 41 sowie entweder in den Pufferkondensator 40 oder den zweiten Kondensator 50 in einer besonders einfachen Weise, die keine Steuerung durch den Kontroller 23 erfordert. Nachteilig bei dem Einsatz von Dioden 62, 72 ist jedoch, dass sich aufgrund der Diodenspannung eine Verlustspannung in den Dioden 62, 72 einstellt. Deshalb kann vorgesehen sein, nur eines von Speisegleichrichterelement 42 und zweitem Gleichrichterelement 52, vorzugsweise das zweite Gleichrichterelement 52, über das geringere Ströme geführt werden, als Diode auszuführen.

Bei dem Ausführungsbeispiel in der Figur 2 ist der Entladekreis 51 als einfacher Entladewiderstand 71, auch englisch Bleed-Resistor genannt, ausgeführt. Der Entladewiderstand 71 entlädt den zweiten Kondensator 50 fortwährend, so dass bei Unterbrechen des Stromflusses durch das zweite Gleichrichterelement 52 bzw. die Diode 72 die Spannung des zweiten Kondensators 50 abhängig von der Kapazität des zweiten Kondensators 50 und dem Widerstandswert des Entladewiderstandes 71 sinkt.

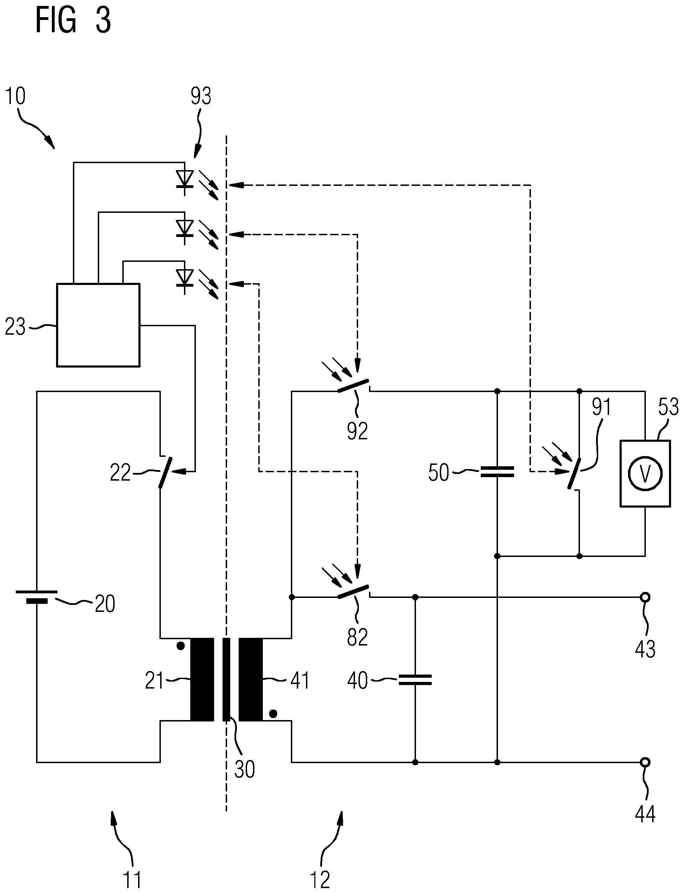

Figur 3 zeigt ein drittes Ausführungsbeispiel eines erfindungsgemäßen Sperrwandlers 10, das wiederum in seinem prinzipiellen Aufbau demjenigen der anderen Ausführungsbeispiele weitgehend entspricht, weshalb nachfolgend erneut lediglich auf die Besonderheiten des dritten Ausführungsbeispiels eingegangen wird.

Bei dem dritten Ausführungsbeispiel des erfindungsgemäßen Sperrwandlers 10 sind das Speisegleichrichterelement 42, das zweite Gleichrichterelement 52 und der Entladekreis 51 als Schalter ausgeführt. Dabei können insbesondere Halbleiterschalter zum Einsatz kommen, die durch ein jeweiliges potentialgetrenntes Signal geschaltet werden, im Beispiel gezeigt, aber nicht darauf beschränkt als optische Trennung; alternativ könnte auch eine magnetische Kopplung oder eine Ableitung der Steuersignale im Sekundärkreis 12 selbst aus den Spannungsverläufen an der Sekundärinduktivität 41 vorgesehen werden. Vorliegend werden die Schalter 82, 91, 92 durch jeweilige Leuchtdioden 93 angesteuert, so dass die Leuchtdioden 93 und die Schalter 82, 91, 92 Optokoppler ausbilden, die in bekannter Weise eine galvanische Trennung bieten. Die Leuchtdioden 93 werden dabei durch den Kontroller 23 angesteuert, so dass der Kontroller 23 unter Beibehaltung der galvanischen Trennung von Primär- und Sekundärkreis 11, 12 sowohl die Schalter des Primär- als auch des Sekundärkreises 11, 12 steuert. Alternativ kann der Kontroller 23 auch dem Sekundärkreis 12 zugerechnet werden, so dass ein Optokoppler oder vergleichbares Mittel nur für die Steuerung des Schalters 22 des Primärkreises 11 vorgesehen werden muss. Die Zuordnung des Kontrollers 23 zu dem Primärkreis 11 oder dem Sekundärkreis 12 ist im Rahmen der Erfindung in zueinander äquivalenter Weise möglich.

Die Verwendung von Schaltern 82, 91, 92 besitzt den Vorteil einer reduzierten Verlustleistung (Schalter 82, 92) sowie einer schnellen und vollständigen Entladung des zweiten Kondensators 50 (Schalter 91).

Die in den Ausführungsbeispielen gezeigten unterschiedlichen Implementierungen des Speisegleichrichterelements 42, des zweiten Gleichrichterelements 52 und des Entladekreises 51 können frei in beliebiger Weise miteinander kombiniert werden, so dass ohne weiteres auf weitere Ausführungsbeispiele der Erfindung geschlossen werden kann.

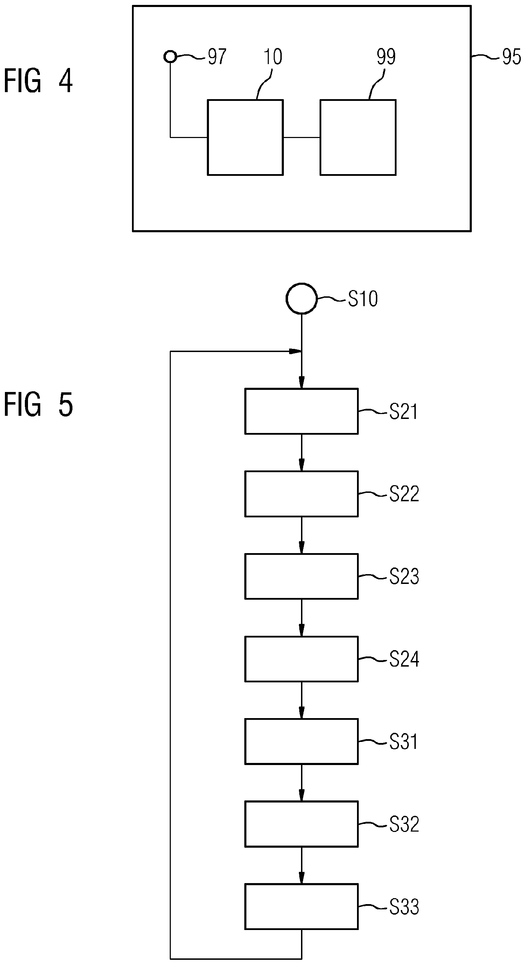

Figur 4 zeigt ein Schutz- oder Steuergerät 95 für ein Hoch- oder Mittelspannungsnetz als Anwendungsbeispiel eines erfindungsgemäßen Sperrwandlers 10. Das Schutz- oder Steuergerät 95 ist für Steuer- und/oder Schutzzwecke in einem Hoch- oder Mittelspannungsnetz vorgesehen. Beispielsweise kann das Schutz- oder Steuergerät 95 Spannungen und Ströme in einem 3-Leiter- oder 4-Leiter-Netz überwachen und anhand des transienten Verhaltens der überwachten Größen auf einen eventuellen Fehlerfall schließen. Stellt das Schutz- oder Steuergerät 95 einen solchen Fehlerfall fest, kann es an einen oder mehrere mit dem Schutz- oder Steuergerät 95 verbundene Schalter ein Auslösesignal übermitteln, woraufhin die Schalter den Netzabschnitt, in dem der Fehler aufgetreten ist, vom restlichen Netz abtrennen. Zu diesem Zweck kann das Schutz- oder Steuergerät 95 analoge und/oder binäre Ein- und Ausgänge umfassen. Da Funktionalität und Aufbau derartiger Schutz- oder Steuergeräte nicht Kern der vorliegenden Erfindung sind, werden die zugehörigen Details in der Figur 4 wie auch der weiteren Beschreibung ausgespart. Es ist jedoch so, dass zur fortlaufenden Einschätzung eines Ausfallrisikos eines jeweiligen Schutz- oder Steuergerätes auch der Zustand seiner Versorgungsspannung, der sogenannten Hilfsspannung, berücksichtigt werden sollte. Diesem Bedürfnis trägt das Schutz- oder Steuergerät 95 der Figur 4 durch den Einsatz eines erfindungsgemäßen Sperrwandlers 10 Rechnung, der zwischen einen Anschluss 97 für die Hilfsspannung (beispielsweise durch einen externen Anschluss oder von einer Batterie) und Versorgungsanschlüsse einer Steuereinheit 99 geschaltet ist, die die eigentliche wesentliche Funktionalität des Schutz- oder Steuergerätes 95 verwirklicht. Der erfindungsgemäße Sperrwandler 10 erlaubt es der Steuereinheit 99, einen Zustand der Eingangsspannung und damit der Hilfsspannung des Schutz- oder Steuergerätes 95 zu erfassen, ohne die gewünschte galvanische Trennung zwischen der Hilfsspannung und dem Schaltkreis um die Steuereinheit 99 aufzuheben. Die Steuereinheit 99 kann dann den erfassten Zustand selbst verarbeiten oder datentechnisch an eine Netzsteuerzentrale des Netzbetreibers übermitteln, wo gegebenenfalls vorbereitende Maßnahmen auf einen drohenden Ausfall des Schutz- oder Steuergerätes 95 wie beispielsweise ein Austausch einer Batterie, aus der die Hilfsspannung gespeist wird, getroffen werden können.

Figur 5 zeigt ein Flussdiagramm eines Ausführungsbeispiels eines erfindungsgemäßen Verfahrens für das Betreiben eines Sperrwandlers, beispielsweise eines Sperrwandlers, wie er in den Figuren 1 bis 3 dargestellt ist. Das Verfahren beginnt in dem Startschritt S10 mit der Inbetriebnahme des Sperrwandlers. Die Betriebsdauer des Sperrwandlers lässt sich in abwechselnd stattfindende Puffer- und Speisephasen unterteilen, wobei vorliegend die Pufferphase Schritte S21, S22, S23 und S24 und die Speisephase Schritte S31, S32 und S33 umfasst.

In Schritt S21 wird ein Strom durch eine Primärinduktivität eines Primärkreises des Sperrwandlers erzeugt, woraufhin von der Primärinduktivität ein entsprechendes Magnetfeld aufgebaut wird. In Schritt S22 wird eine an einen Sekundärkreis des Sperrwandlers angeschlossene Last aus einem Pufferkondensator des Sekundärkreises versorgt. Obwohl der Schritt S22 in dem Flussdiagramm von Figur 5 als in zeitlicher Folge von Schritt S21 stattfindend gezeigt ist, werden beide Schritte üblicherweise gleichzeitig zueinander stattfinden, müssen aber nicht von gleicher Dauer sein. Insbesondere kann der Schritt S22 die gesamte Pufferphase dauern, während Schritt S21 nur einen Teil der Pufferphase einnehmen kann.

In Schritt S23 wird ein Kondensator in einem Sekundärkreis des Sperrwandlers (beispielsweise der zweite Kondensator in den beispielhaften Schaltungen der Figuren 1 bis 3) wenigstens teilweise entladen. Dadurch können Änderungen des Zustandes der Eingangsspannung des Sperrwandlers zeitlich erfasst werden, da die Spannung des Kondensators mit jedem Durchlaufen der Hauptschleife des erfindungsgemäßen Verfahrens neu aufgebaut wird. Auch der Schritt S23 kann gleichzeitig zu anderen Schritten des Verfahrens ausgeführt werden, obgleich er in dem gezeigten Flussdiagramm als auf den Schritt S22 folgend dargestellt ist.

In Schritt S24 wird ein Strom aus der Sekundärinduktivität in den Kondensator in dem Sekundärkreis erzeugt, um den Kondensator auf eine Spannung aufzuladen, welche einen direkten Rückschluss auf die an der Primärinduktivität anliegende Spannung zu erhalten. Der Schritt S24 wird üblicherweise nur einen Teil der Pufferphase dauern und kann ebenfalls gleichzeitig zu einem oder mehreren der Schritte S21, S22 und S23 ausgeführt werden.

Auf die Pufferphase folgt die Speisephase, die im gezeigten Beispiel die Schritte S31, S32 und S33 umfasst. Im Schritt S31 wird der Strom durch die Primärinduktivität gesperrt. Da das von der Primärinduktivität aufgebaute Magnetfeld aufgrund der magnetischen Kopplung der Primärinduktivität mit einer Sekundärinduktivität auch in letztgenannter wirkt, wird in dem sich anschließenden Schritt S32 der Pufferkondensator des Sekundärkreises aus der Sekundärinduktivität aufgeladen. In diesem Schritt, der einen Teil oder auch die gesamte Speisephase andauern kann, wird also die in der Pufferphase von dem Pufferkondensator zur Versorgung der an den Sperrwandler angeschlossenen Last von der Primärseite auf die Sekundärseite des Sperrwandlers übertragen.

In Schritt S33 wird schließlich eine Spannung über den während der Pufferphase aufgeladenen zweiten Kondensator bestimmt. Der Schritt S33 kann prinzipiell auch an anderer Stelle des Verfahrens als in Figur 5 gezeigt ausgeführt werden und wurde hier lediglich beispielhaft als abschließender Schritt gezeigt, bevor das Verfahren zu Schritt S21 zurückverzweigt. Beispielsweise kann Schritt S33 auch während der Pufferphase durchgeführt werden.

Bei der Darstellung des erfindungsgemäßen Verfahrens in Figur 5 wurden aus Gründen der Vereinfachung Schritte ausgelassen, die ein im Stand der Technik prinzipiell bekanntes Regelungsverfahren für eine Regelung der Ausgabespannung des Sperrwandlers betreffen. Hier stehen verschiedene Regelungsverfahren zur Verfügung, die jedoch nicht für die Umsetzung der Erfindung wesentlich sind und daher nicht thematisiert werden.

Die Erfindung wurde anhand von Ausführungsbeispielen näher erläutert, soll jedoch nicht durch die die Ausführungsbeispiele beschränkt werden, sondern ist allein durch die nachfolgenden Patentansprüche definiert.

### Bezugszeichenliste

- 10: Sperrwandler
- 11: Primärkreis
- 12: Sekundärkreis
- 20: Gleichspannungsquelle
- 21: Primärinduktivität
- 22: Schalter
- 23: Kontroller
- 30: Magnetkern
- 40: Pufferkondensator
- 41: Sekundärinduktivität
- 42: Speisegleichrichterelement
- 43: erster Lastanschluss
- 44: zweiter Lastanschluss
- 50: zweiter Kondensator
- 51: Entladekreis
- 52: zweites Gleichrichterelement
- 53: Spannungsmesseinheit
- 62: Diode
- 71: Entladewiderstand
- 72: Diode
- 82: Schalter
- 91: Entladeschalter
- 92: Schalter
- 93: Leuchtdioden
- 95: Schutz- oder Steuergerät
- 97: Anschluss für Hilfsspannung
- 99: Steuereinheit

## Patentansprüche

1. Ein Sperrwandler (10) mit einem Primärkreis (11) und einem Sekundärkreis (12), wobei der Primärkreis (11) wenigstens einen Schalter (22), einen Kontroller (23) zum Ansteuern des Schalters (22) und eine Primärinduktivität (21) umfasst und wobei der Sekundärkreis (12) wenigstens eine magnetisch mit der Primärinduktivität (21) gekoppelte Sekundärinduktivität (41), ein Speisegleichrichterelement (42) und einen Pufferkondensator (40) umfasst, wobei das Speisegleichrichterelement (42) dazu ausgebildet ist, einen Strom von der Sekundärinduktivität (41) in einer Speisestromrichtung in den Pufferkondensator (40) fließen zu lassen und entgegen der Speisestromrichtung zu sperren,
**gekennzeichnet durch** einen in dem Sekundärkreis (12) angeordneten zweiten Kondensator (50) und ein zwischen den zweiten Kondensator (50) und die Sekundärinduktivität (41) geschaltetes zweites Gleichrichterelement (52), das ausgebildet ist, einen Messstrom in den zweiten Kondensator (50) fließen zu lassen, wenn das Speisegleichrichterelement (42) den Strom von der Sekundärinduktivität (41) entgegen der Speisestromrichtung sperrt.

2. Der Sperrwandler (10) des vorhergehenden Anspruchs, bei dem wenigstens eines von Speisegleichrichterelement (42) und zweitem Gleichrichterelement (52) als Diode (62, 72) ausgebildet ist.

3. Der Sperrwandler (10) eines der vorhergehenden Ansprüche, bei dem wenigstens eines von Speisegleichrichterelement (42) und zweitem Gleichrichterelement (52) als Schalter (82, 92) ausgebildet ist und eine über eine galvanische Trennung mit einem zugeordneten Steuerausgang des Kontrollers (23) verbundene Steuerelektrode aufweist.

4. Der Sperrwandler (10) eines der vorhergehenden Ansprüche, bei dem der zweite Kondensator (50) zwischen einen Kontakt des zweiten Gleichrichterelements (52) und ein festes Bezugspotential des Sekundärkreises (12) geschaltet ist.

5. Der Sperrwandler (10) eines der vorhergehenden Ansprüche, mit einem mit dem zweiten Kondensator (50) verbundenen Entladekreis (51), der ausgebildet ist, den zweiten Kondensator (50) zu entladen.

6. Der Sperrwandler (10) des vorhergehenden Anspruchs, bei dem der Entladekreis (51) einen Entladewiderstand (71) umfasst.

7. Der Sperrwandler (10) von Anspruch 5, bei dem der Entladekreis (51) einen Entladeschalter (91) umfasst, dessen Steuerelektrode über eine galvanische Trennung mit einem zugeordneten Steuerausgang des Kontrollers (23) verbunden ist.

8. Der Sperrwandler (10) eines der vorhergehenden Ansprüche, bei dem eine Kapazität des Pufferkondensators (40) wenigstens das Zehnfache einer Kapazität des zweiten Kondensators (50) beträgt.

9. Der Sperrwandler (10) eines der vorhergehenden Ansprüche, mit einer Spannungsmesseinheit (53), die mit dem zweiten Kondensator (50) verbunden und dazu ausgebildet, eine Spannung über den zweiten Kondensator (50) zu bestimmen.

10. Ein Schutz- oder Steuergerät (95) für ein Mittel- oder Hochspannungsnetz mit einer Steuereinheit (99) und einem Anschluss (97) für eine Hilfsspannung, **gekennzeichnet durch** einen Sperrwandler (10) gemäß einem der vorhergehenden Ansprüche, welcher zwischen den Anschluss (97) für die Hilfsspannung und die Steuereinheit (99) geschaltet und dazu ausgebildet ist, die Steuereinheit (99) aus der Hilfsspannung zu versorgen.

11. Ein Verfahren für das Betreiben eines Sperrwandlers (10) und mit den folgenden wiederholt ausgeführten Schritten:
- während einer Pufferphase, Erzeugen eines Stromes durch eine Primärinduktivität (21) eines Primärkreises (11) des Sperrwandlers (10);
- während der Pufferphase, Versorgen einer an einen Sekundärkreis (12) des Sperrwandlers (10) angeschlossenen Last aus einem Pufferkondensator (40) des Sekundärkreises (12);
- während einer auf die Pufferphase folgenden Speisephase, Sperren eines Stromes durch die Primärinduktivität (21); und
- während der Speisephase, Aufladen des Pufferkondensators (40) aus einer mit der Primärinduktivität (21) magnetisch gekoppelten Sekundärinduktivität (41),
**gekennzeichnet durch** einen während wenigstens eines Teils der Pufferphase ausgeführten Schritt des Erzeugens eines Stromes aus der Sekundärinduktivität (41) in einen zweiten Kondensator (50).

12. Das Verfahren des vorhergehenden Anspruchs, mit einem Schritt des wenigstens teilweisen Entladens des zweiten Kondensators (50).

13. Das Verfahren eines der Ansprüche 11 oder 12, mit einem Schritt des Bestimmens einer Spannung über den zweiten Kondensator (50).
